# EUROPÄISCHE PATENTSCHRIFT

(11) **EP 2 625 446 B1**
(45) Veröffentlichungstag und Bekanntmachung des Hinweises auf die Patenterteilung: **22.04.2015**
(21) Anmeldenummer: 11797181.2
(22) Anmeldetag: 02.09.2011
(51) Int. Cl.: F16J 9/26

(54) **VERFAHREN ZUR HERSTELLUNG EINES KOLBENRINGS**
METHOD FOR PRODUCING A PISTON RING
PROCÉDÉ DE FABRICATION D'UN SEGMENT DE PISTON

(30) Priorität: 07.10.2010 DE 102010047836
(43) Veröffentlichungstag der Anmeldung: 14.08.2013
(73) Patentinhaber: Federal-Mogul Burscheid GmbH, 51399 Burscheid (DE)
(72) Erfinder: ESSER, Peter-Klaus, 51515 Kürten (DE)
(74) Vertreter: Döpp, Ludger
(86) Internationale Anmeldenummer: PCT/DE2011/001684
(87) Internationale Veröffentlichungsnummer: WO 2012/045294

(56) Entgegenhaltungen:
- WO-A1-2011/064888
- DE-A1-102010 001 434
- DE-B3- 10 359 802
- GB-A- 1 441 961

## Beschreibung

Die Erfindung betrifft ein Verfahren zur Herstellung eines Kolbenrings gemäß gattungsbildendem Teil des ersten Patentanspruchs.

Allgemein bekannt ist, dass zur Verbesserung der Abstreifwirkung, insbesondere von Kompressionskolbenringen, die Ringlauffläche einseitig gekammert oder vollgekammert ausgeführt wird. Ebenfalls allgemein bekannt ist, dass die Lauffläche von mit Kammern versehenen Kompressionskolbenringen mit Chromschichten versehen wird.

Der WO 2008/098534 A1 ist ein Kolbenring zu entnehmen, mit einem Grundkörper, der eine mit einer Kammerung versehene Lauffläche, eine obere und eine untere Flankenfläche sowie eine innere Umfangsfläche aufweist. Auf der Lauffläche ist mindestens eine PVD-Deckschicht aufgebracht, dergestalt, dass der Grundkörper in seinem fertigen Zustand lediglich randbereichsseitig, d.h. außerhalb der Kammerung die Deckschicht aufweist. Hier ist es im Bereich des Randes möglich, dass die relativ harte PVD-Schicht im Betriebszustand ausbricht und die Abstreifwirkung der Kante dadurch gemindert wird.

Die DE 10 2006 046 915 B3 offenbart einen Kolbenring für Verbrennungskraftmaschinen, beinhaltend ein Trägermaterial, insbesondere aus Stahl oder einem Gusseisen, und mit einer Verschleißschutzbeschichtung aus einem periodisch aufgebauten Viellagenschichtsystem, wobei jede Periodizität aus mindestens zwei Einzellagen aus Metallnitriten besteht.

Der GB 1441961 ist ein gattungsgemäßes Verfahren zur Herstellung eines Kolbenrings zu entnehmen.

Die WO 2011/064888 A1 offenbart einen Kolbenring, der eine einseitige Kammerung aufweist, in welcher eine verschleißfeste Schicht eingebracht ist. Die verschleißfeste Schicht wird aus unterschiedlichen Materialien gebildet, wobei die erste Schicht durch eine Hartstoffschicht gebildet ist und die zweite Schicht einen andersartigen Schichtaufbau beinhaltet.

Durch die DE 103 59 802 B3 ist ein Kolbenring sowie ein Verfahren zur Herstellung desselben bekannt geworden. Zur Erzeugung einer Aufdampfschicht auf einer mit einem Laufflächenprofil vorgesehenen Lauffläche eines Kolbenrings wird ein mit dem Laufflächenprofil versehener Grundkörper außerhalb des Laufflächenprofils mit einer Abdeckung versehen. Anschließend wird die Aufdampfschicht auf die Lauffläche aufgebracht und anschließend die Abdeckung entfernt, so dass im Anschluss an die Entfernung der Abdeckung zwischen der Lauffläche und mindestens einer der Flankenflächen des Grundkörpers eine im Wesentlichen scharfkantige Lauffläche gebildet wird. Die Aufdampfschicht kann durch das PVD- oder CVD-Verfahren erzeugt werden.

Der Erfindung liegt die Aufgabe zugrunde, ein alternatives Verfahren zur Erzeugung von mit mindestens einer PVD-Schicht versehenen Kolbenringen bereitzustellen, bei welchem der Kolbenring gegenüber dem Stand der Technik eine verbesserte Abstreifwirkung und eine geringere Ausbruchgefahr hat.

Darüber hinaus soll ein Kolbenring mit erhöhter Ausbruchsicherheit, insbesondere im Bereich der Abstreifkante (Funktionskante) konzipiert werden.

Diese Aufgabe wird dadurch gelöst, dass zumindest Teilbereiche der Lauffläche und/oder der Kammerung nitriert und anschließend die Lauffläche mit einer PVD-Deckschicht oder einem Viellagenschichtsystem versehen wird.

Vorteilhafte Weiterbildungen des erfindungsgemäßen Verfahrens sind den zugehörigen verfahrensgemäßen Unteransprüchen zu entnehmen.

Diese Aufgabe wird auch gelöst durch einen nach diesem Verfahren hergestellten Kolbenring, der vorteilhafterweise laufflächenseitig einseitig gekammert oder vollgekammert ist, wobei im gekammerten Bereich der Lauffläche bodenseitig eine, von der zylindrischen Form abweichende Kontur eingebracht und der gekammerte Bereich der Lauffläche im fertigen Zustand des Kolbenrings mit mindestens einer verschleißfesten Schicht versehen ist.

Vorteilhafte Weiterbildungen des Kolbenrings sind den zugehörigen gegenständlichen Unteransprüchen zu entnehmen.

Mit dem erfindungsgemäßen Verfahren und dem danach hergestellten Kolbenring kann eine Verbesserung der Abstreifwirkung der gebildeten scharfen Abstreifkante herbeigeführt werden. Da im Bereich der Abstreifkante kein verschleißfestes (hartes) Material gegeben ist, wird hier eine sich selbst schärfende Abstreifkante (Funktionskante) gebildet, welche nicht ausbruchsgefährdet ist.

Die jeweilige Kontur im Bereich des Bodens der Kammerung wird vorteilhafterweise mechanisch eingebracht.

Je nach Anwendungsfall kann es sinnvoll sein, den Boden des gekammerten Bereichs mit einer geradlinig schräg oder gewölbt verlaufenden Kontur zu versehen.

Sofern gewünscht, kann die Lauffläche entweder nur mit einer PVD-bzw. DLC-Deckschicht versehen werden, oder aber es kommt ein Viellagenschichtsystem, wie in der DE 10 2006 046 915 B3 beschrieben, zum Einsatz.

Die nach dem insbesondere zylindrischen Bearbeiten freigelegte Stegbreite der Lauffläche liegt, einem weiteren Gedanken der Erfindung gemäß, zwischen 0,05 und 0,45 mm.

Der Kolbenringgrundkörper kann aus Gusseisen, Stahlguss oder Stahldraht bestehen, wobei in Abhängigkeit von dem gewählten Ausgangswerkstoff die Abstreifkante scharfkantig, gerundet oder mit Schrägen versehen werden kann.

Die Abstreifkante bei einem Gusseisenkolbenring kann beispielsweise scharfkantig (90°) ausgeführt, oder je nach Anforderung mit einem Radius von 0,1 mm abgerundet werden.

Bei einem Stahlring kann der Bereich der Abstreifkante nitriert oder unnitriert ausgeführt werden. In nicht-nitrierter Ausführung kann die Abstreifkante ebenfalls scharfkantig (90°) erzeugt werden.

Bei nitrierter Stahlringausführung kann es bedarfsweise folgende Ringausführungen geben:
- die Abstreifkante beinhaltet einen radialen Einzug < 0,1 mm, der Stahlsteg und die Lauffläche sind nitriert, wobei es nach Fertigstellung des Kolbenrings keine Nitrierschicht unterhalb der PVD-Deckschicht gibt;
- die Abstreifkante wird mit einer Abschrägung < 0,15 mm versehen, der Stahlsteg und die Lauffläche sind nitriert, wobei bei dem fertigen Ring eine Nitrierschicht unterhalb der PVD-Deckschicht verbleibt.

Je nach Werkstoff und Anwendungsfall können somit Kolbenringe, insbesondere Kompressionskolbenringe, erzeugt werden, die mit mindestens einer verschleißfesten Schicht, vorzugsweise einer PVD-Schicht, respektive einem Viellagenschichtsystem, versehen sind.

Ist die PVD-Schicht bereits als einzige Deckschicht anzusehen, wird selbige im Bereich der Abstreifkante bis auf das Grundmaterial etwa zylindrisch abgetragen, so wird ein beschichtungsfreier Steg vorgebbarer Breite erzeugt.

Sind mehrere Verschleißschichten gegeben, so kann die PVD-Deckschicht entweder bis auf das Grundmaterial der Lauffläche abgeschliffen werden oder aber lediglich so weit, dass mindestens eine verschleißfeste Schicht (beispielsweise eine Nitrierschicht) unterhalb der PVD-Deckschicht verbleibt.

Je nach Anwendungsfall kann es ebenfalls sinnvoll sein, die fertiggestellte und beschichtete Lauffläche mit einem balligen Profil, beispielsweise durch Läppen oder Honen zu versehen.

Der Erfindungsgegenstand ist anhand eines Ausführungsbeispiels in der Zeichnung dargestellt und wird wie folgt beschrieben. Es zeigen:
- Figur 1: Herstellungsprozess eines einseitig gekammerten Kolbenrings;
- Figur 2: Herstellungsprozess eines vollständig gekammerten Kolbenrings;
- Figur 3: Unterschiedliche Ausgestaltungsformen der Abstreifkante eines einseitig gekammerten Kolbenrings gemäß Figur 1.

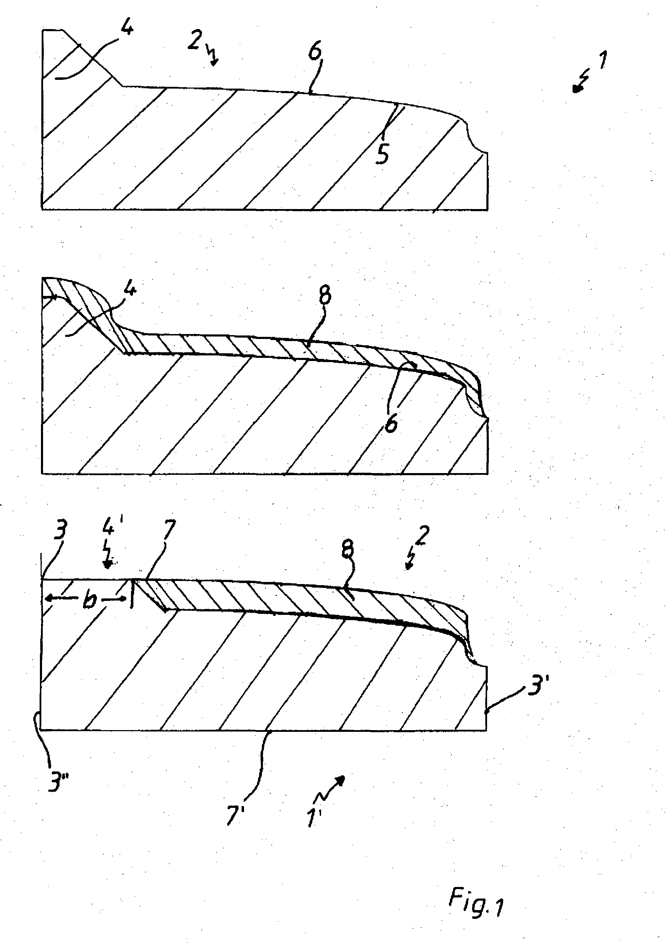

Figur 1 enthält drei Bilder. Das obere Bild zeigt in vergrößerter Darstellung einen Kolbenringgrundkörper 1, der bereits mit einer einseitigen Kammerung 2 versehen ist. Im Bereich der späteren Abstreifkante 3 verbleibt zunächst einmal ein Steg 4. Der Boden 5 der Kammerung 2 ist mit einem, von der zylindrischen Form abweichenden balligen Profil 6 versehen.

Im mittleren Bild erkennbar ist, dass auf der späteren Lauffläche 7 eine PVD-Deckschicht 8 aufgebracht wurde, die der Kontur, einerseits des Stegs 4 und andererseits des Bodens 6 folgt.

Alternativ kann auch eine der DE 10 2006 046 915 B3 entsprechende Verschleißschutzbeschichtung auf dem Boden 6, respektive dem Steg 4, aufgebracht werden.

Das untere Bild der Figur 1 zeigt nun den fertigen Kolbenring 1'. Der im mittleren Bild noch erkennbare Steg 4 wurde so weit abgetragen, dass ein Steg 4' mit vorgebbarer Breite b gebildet wurde, der nun auch die in diesem Bild scharfkantige Abstreifkante 3 enthält. Der fertige Kolbenring 1' verfügt somit ausschließlich im Bereich der Kammerung 2 über die PVD-Deckschicht 8, während der Steg 4', über seine Breite b gesehen, beschichtungsfrei ausgeführt ist. Durch diese Maßnahme wird eine sich im Betriebszustand ständig selbst schärfende Abstreifkante 3 gebildet. Ebenfalls erkennbar ist, die der Lauffläche 7 radial gegenüberliegende innere Umfangsfläche 7' sowie die obere und die untere Flankenfläche 3',3".

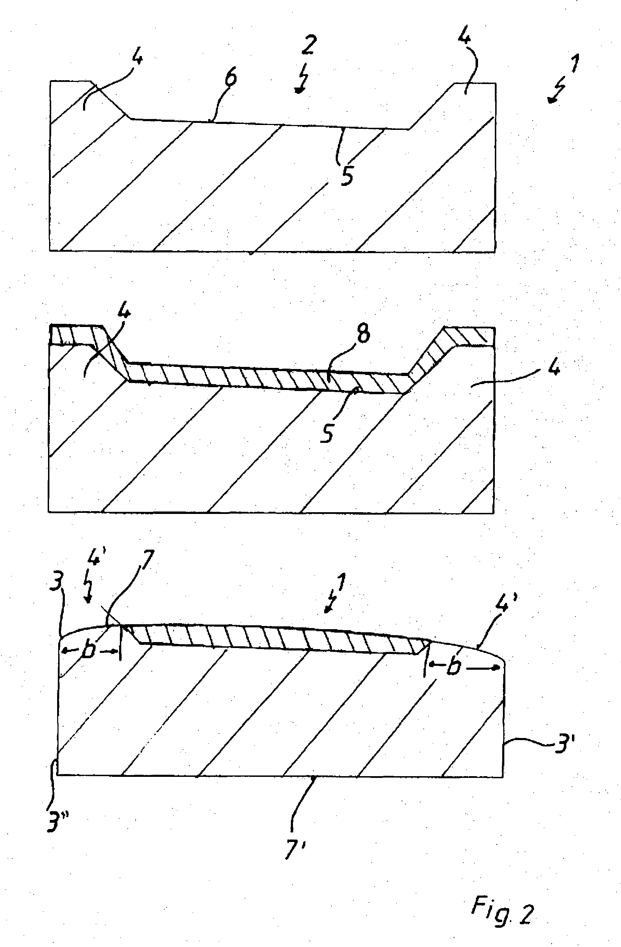

Figur 2 zeigt ebenfalls drei Bilder, wobei der im oberen Bild dargestellte Kolbenringgrundkörper 1 eine so genannte Vollkammer 2 enthält, bei welcher zwei äußere Stege 4 gegeben sind. Auch hier ist der Boden 5 mit einer geradlinig schräg verlaufenden Kontur 6 ausgebildet. Die zylindrische Form ist gestrichelt angedeutet.

Im mittleren Bild der Figur 2 ist erkennbar, dass entweder eine einzelne PVD-Deckschicht 8, oder aber ein Viellagenschichtsystem auf der späteren Lauffläche 7 aufgebracht wurde, die der Kontur, sowohl der Stege 4 als auch des Bodens 5, folgt. Abweichend zu Figur 1 ist die spätere Abstreifkante 3 nicht scharfkantig ausgeführt, sondern verfügt über einen Radius vorgebbarer Abmessung. Ebenfalls abweichend zu Figur 1 ist, dass die Lauffläche 7 im Bereich der jetzigen Stege 4'vorgegebene Breiten b aufweist und, dass die Lauffläche 7, sowohl im Bereich der jetzt gegebenen Stege 4' als auch der Kammerung 2, einem Rundläppvorgang unterzogen wurde. Ebenfalls erkennbar ist die innere Umfangsfläche 7', die obere 3' und die untere Flankenfläche 3''.

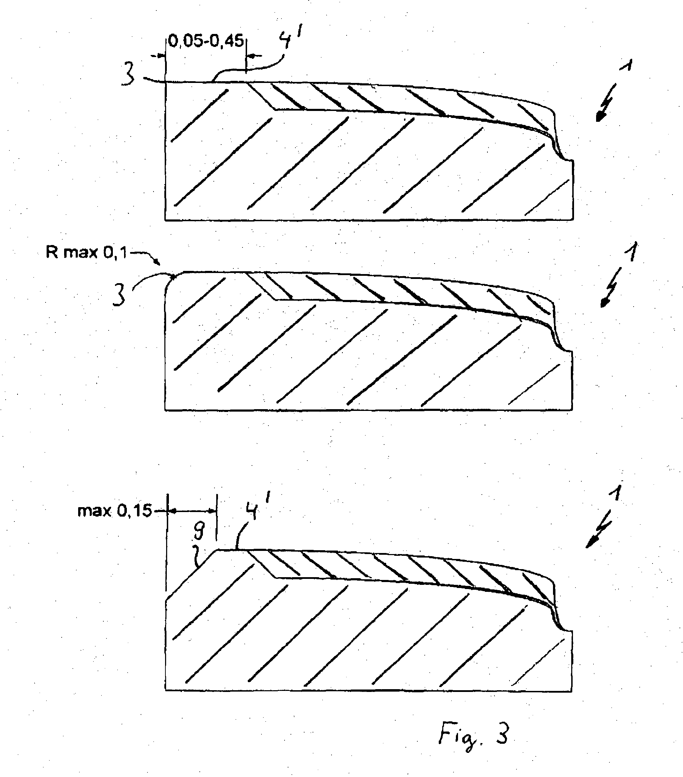

Figur 3 zeigt unterschiedliche Ausgestaltungsformen eines fertigen Kolbenrings 1. Die Kontur orientiert sich am unteren Bild der Figur 1. Erkennbar ist im oberen Bild der Figur 3 die scharfe Abstreifkante 3 sowie der Steg 4', der in diesem Beispiel eine Breite zwischen 0,05 und 0,45 mm haben soll.

Im mittleren Bild der Figur 3 erkennbar ist, dass die Abstreifkante 3 einen Radius R max. von 0,1 mm haben soll.

Das untere Bild der Figur 3 zeigt, dass der Steg 4' über eine Schräge 9 einer Gesamtbreite von max. 0,15 mm in die untere Ringflanke des Kolbenrings 1 einläuft.

## Patentansprüche

1. Verfahren zur Herstellung eines Kolbenrings (1'), indem ein metallischer Grundkörper (1), der eine radial äußere Lauffläche (7), eine radial innere Umfangsfläche (7') sowie dazwischen verlaufende Flankenflächen (3',3") aufweist, laufflächenseitig mit einer Kammerung (2) versehen wird, zumindest der Boden (5) der Kammerung (2) mit einer, von einer zylindrischen Form abweichenden Kontur (6) versehen wird, die Lauffläche (7) einschließlich der Kammerung (2) mit mindestens einer verschleißfesten Schicht (8) versehen wird, wobei die mindestens eine Verschleißschicht (8), einen Steg (4') vorgebbarer Breite (b) samt Abstreifkante (3) bildend, zumindest partiell abgetragen wird, **dadurch gekennzeichnet, dass** zumindest Teilbereiche der Lauffläche (7) und/oder der Kammerung (2) nitriert und anschließend die Lauffläche (7) mit einer PVD-Deckschicht (8) oder einem Viellagenschichtsystem (8) versehen wird.

2. Verfahren nach Anspruch 1, **dadurch gekennzeichnet, dass** die jeweilige Kontur (6), zumindest des Bodens (5) der Kammerung (2), mechanisch eingebracht wird.

3. Verfahren nach Anspruch 1 oder 2, **dadurch gekennzeichnet, dass** die Kammerung (2) mit einer geradlinig schräg oder gewölbt verlaufenden Kontur (6) versehen wird.

4. Verfahren nach einem der Ansprüche 1 bis 3, **dadurch gekennzeichnet, dass** der Bereich der Abstreifkante (3) in nitrierter Form vorgesehen wird.

5. Verfahren nach einem der Ansprüche 1 bis 4, **dadurch gekennzeichnet, dass** die Abstreifkante (3) scharfkantig ausgebildet wird.

6. Verfahren nach einem der Ansprüche 1 bis 4, **dadurch gekennzeichnet, dass** die Abstreifkante (3) mit einer in die zugehörige Flanke (3") unter einem Radius (R) von maximal 0,2 mm einlaufenden Rundung versehen wird.

7. Verfahren nach einem der Ansprüche 1 bis 4, **dadurch gekennzeichnet, dass** die Abstreifkante (3) mit einer in die zugehörige Flanke (3") unter einem Winkel größer 30° einlaufenden Abschrägung (9) versehen wird.

8. Verfahren nach einem der Ansprüche 1 bis 7, **dadurch gekennzeichnet, dass** ein Grundkörper (1) aus Gusseisen, Stahlguss oder Stahldraht eingesetzt wird.

9. Kompressionskolbenring, hergestellt nach dem Verfahren gemäß einem der Ansprüche 1 bis 8.

10. Kolbenring nach Anspruch 9, der laufflächenseitig einseitig gekammert oder vollgekammert ist, wobei im gekammerten Bereich der Lauffläche (7) bodenseitig eine von der zylindrischen Form abweichende Kontur (6) eingebracht und die Kammerung (2) der Lauffläche (7) im fertigen Zustand des Kolbenrings (1') mit mindestens einer verschleißfesten Schicht (8) versehen ist.

11. Kolbenring nach Anspruch 9 oder 10, **dadurch gekennzeichnet, dass** die Kammerung (2) mit mindestens einer PVD-Deckschicht (8) versehen ist.

12. Kolbenring nach einem der Ansprüche 9 bis 11, **dadurch gekennzeichnet, dass** die Kammerung (2) mit einem Viellagenschichtsystem (8) versehen ist.

## Claims

1. A method for manufacturing a piston ring (1'), in that a metallic base body (1) at least comprising a radial outer bearing surface (7), a radial inner circumferential surface (7') as well as flank surfaces (3', 3") which extend between them is provided with a chambering (2) on the bearing surface, at least the bottom (5) of the chambering (2) is provided with a contour (6) which differs from a cylindrical form, the bearing surface (7) including the chambering (2) is provided with at least one wear-resistant layer (8), wherein the at least one wear-resistant layer (8) is at least partially removed while forming a web (4') of pre-determinable width (b) including a strip edge (3), **characterized in that** at least partial areas of the bearing surface (7) and/or the chambering (2) are nitrated and afterwards the bearing surface (7) is provided with a PVD cover layer (8) or with a multi-layer system (8).

2. A method according to claim 1, **characterized in that** the respective contour (6) of at least the bottom (5) of the chambering (2) is mechanically formed.

3. A method according to claim 1 or 2, **characterized in that** the chambering (2) is provided with a linearly oblique or curved contour (6).

4. A method according to one of the claims 1 through 3, **characterized in that** the area of the strip edge (3) is provided in nitrated form.

5. A method according to one of the claims 1 through 4, **characterized in that** the strip edge (3) is made sharp-edged.

6. A method according to one of the claims 1 through 4, **characterized in that** the strip edge (3) is provided with a curvature that passes into the associated flank (3") with a radius of maximum 0.2 mm.

7. A method according to one of the claims 1 through 4, **characterized in that** the strip edge (3) is provided with a bevel (9) which passes into the associated flank (3") under an angle of > 30°.

8. A method according to one of the claims 1 through 7, **characterized in that** a base body (1) made of cast iron, steel cast or steel wire is used.

9. A compression piston ring manufactured according to the method according to one of the claims 1 through 8.

10. A piston ring according to claim 9, which is chambered on one side or on all sides of the bearing surface, wherein in the chambered zone of the bearing surface (7) a contour (6) which differs from the cylindrical form is applied to the bottom side and the chambering (2) of the bearing surface (7) is provided with at least one wear-resistant layer (8) in the final state of the piston ring (1').

11. A piston ring according to claim 9 or 10, **characterized in that** the chambering (2) is provided with at least one PVD cover layer (8).

12. A piston ring according to one of the claims 9 through 11, **characterized in that** the chambering (2) is provided with a multi-layer system (8).

## Revendications

1. Procédé de fabrication d'un segment de piston (1') en munissant un corps de base (1) métallique comprenant au moins une surface de glissement radiale extérieure (7), une surface circonférentielle radiale intérieure (7') ainsi que des surfaces de flanc (3', 3") qui s'étendent entre elles d'un chambrage (2) du côté de la surface de glissement, au moins le fond (5) du chambrage (2) étant muni d'un contour (6) différant d'une forme cylindrique et la surface de glissement (7), le chambrage (2) y compris, étant muni d'au moins une couche résistante à l'usure (8), l'au moins une couche résistante à l'usure (8) étant au moins partiellement enlevée en formant une entretoise (4') de largeur pré-définissable (b) ensemble avec une arrête de raclage (3), **caractérisé en ce qu'**au moins des parties partielles de la surface de glissement (7) et/ou du chambrage (2) sont nitrurées et la surface de glissement (7) est ensuite munie d'une couche de couverture en PVD (8) ou d'un système multicouches (8).

2. Procédé selon la revendication 1, **caractérisé en ce que** le contour (6) respectif, au moins du fond (3) du chambrage (2), est formé mécaniquement.

3. Procédé selon la revendication 1 ou la revendication 2, **caractérisé en ce que** le chambrage (2) est muni d'un contour (6) linéairement incliné ou bombé.

4. Procédé selon l'une des revendications 1 à 3, **caractérisé en ce que** la zone de l'arrête de raclage (3) est prévue sous forme nitrurée.

5. Procédé selon l'une des revendications 1 à 4, **caractérisé en ce que** l'arrête de raclage (3) est configurée comme une arrête acérée.

6. Procédé selon l'une des revendications 1 à 4, **caractérisé en ce que** l'arrête de raclage (3) est formée avec une courbure qui passe dans le flanc associé (3") avec un rayon de maximum 0,2 mm.

7. Procédé selon l'une des revendications 1 à 4, **caractérisé en ce que** l'arrête de raclage (3) est munie d'un biseau (9) qui passe dans le flanc associé (3") sous un angle de plus de 30°.

8. Procédé selon l'une des revendications 1 à 7, **caractérisé en ce qu'**on utilise un corps de base (1) en fonte, en acier coulé ou en fil d'acier.

9. Segment de piston de compression fabriqué selon le procédé selon l'une des revendications 1 à 8.

10. Segment de piston selon la revendication 9, qui est chambré sur un côté ou sur tous les côtés de la surface de glissement, un contour (6) différant de la forme cylindrique étant donné au côté du fond dans la zone chambrée de la surface de glissement (7) et le chambrage (2) de la surface de glissement (2) étant muni d'au moins une couche résistante à l'usure (8) dans l'état fini du segment de piston (1').

11. Segment de piston selon la revendication 9 ou la revendication 10, **caractérisé en ce que** le chambrage (2) est muni d'au moins une couche de couverture en PVD (8).

12. Segment de piston selon l'une des revendications 9 à 11, **caractérisé en ce que** le chambrage (2) est muni d'un système multicouches (8).
